# EUROPEAN PATENT SPECIFICATION

(11) **EP 1 705 199 B1**
(45) Date of publication and mention of the grant of the patent: **17.06.2009**
(21) Application number: 06251618.2
(22) Date of filing: 24.03.2006
(51) Int. Cl.: C08G 59/40, C08G 59/68, C07F 9/54, C08L 63/00

(54) **Semiconductor encapsulating epoxy resin composition and semiconductor device**
Epoxidharz Halbleiterverkapselungszusammensetzung und Halbleitervorrichtung
Composition de résine d'epoxy pour encapsuler des semi-conducteurs et dispositif de semi-conducteur

(30) Priority: 24.03.2005 JP 2005085799
(43) Date of publication of application: 27.09.2006
(73) Proprietor: Shin-Etsu Chemical Co., Ltd., Tokyo (JP)
(72) Inventor: Osada, Shoichi, Silicone-Electr. Mat. Res. Ctr., Matsuida-machi Usui-gun Gunma-Ken (JP)
(74) Representative: Stoner, Gerard Patrick

(56) References cited:
- EP-A- 0 595 230
- EP-A- 1 369 445
- JP-A- 3 040 459

## Description

This invention relates to an epoxy resin composition for semiconductor encapsulation which is effectively moldable and cures into a product having a high glass transition temperature, high-temperature and moisture-proof reliability, thermal shock resistance and a low dielectric constant. It also relates to a semiconductor device encapsulated with a cured product of the composition.

### BACKGROUND

The current mainstream of semiconductor devices including diodes, transistors, ICs, LSIs and VLSIs are of the resin encapsulation type. Epoxy resins have superior moldability, adhesion, electrical properties, mechanical properties, and moisture resistance to other thermosetting resins. It is thus a common practice to encapsulate semiconductor devices with epoxy resin compositions.

There is an increasing demand to use semiconductor devices in more stringent environments. In the automobile-related electronic part field, for example, studies have been made to install electronic control units and system modules around engines. This requires further improvements in high-temperature resistance and thermal shock resistance of semiconductor devices.

In the communications field, the mobile phone information communications technology utilizes higher frequencies, which requires lower dielectric constants and improved heat resistance. To meet such requirements, studies have been made on composite materials of conventional epoxy resins with high-temperature resins. For example, thermosetting resins like epoxy resins having maleimide compounds incorporated therein via alkenyl groups are under investigation as a candidate for semiconductor encapsulation.

An object of the present invention is to provide a semiconductor encapsulant which is effectively moldable and has a high glass transition temperature, high-temperature reliability, thermal shock resistance and a low dielectric constant. Corresponding uses and products are other aspects.

The present invention provides a semiconductor encapsulating epoxy resin composition comprising
(A) an epoxy resin,
(B) optionally, a curing agent (preferably phenolic resin),
(C) an inorganic filler,
(D) a cure accelerator having the general formula (1): 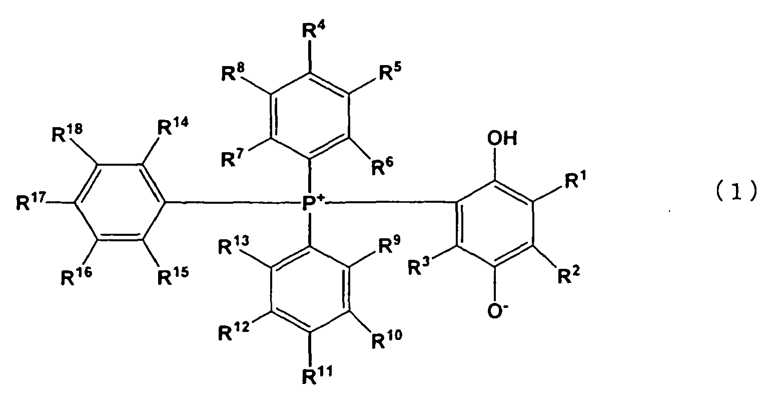 wherein R¹, R², and R³ are each independently hydrogen, C₁-C₄ alkyl, aryl, or hydroxyl, and R⁴ to R¹⁸ are each independently hydrogen, C₁-C₄ alkyl or alkoxy.
(E) a compound having at least two maleimide groups in a molecule, and
(F) a phenol having at least one alkenyl group in a molecule.

This epoxy resin composition is effectively moldable and cures into a product having a high glass transition temperature (Tg) and a low dielectric constant. A semiconductor device encapsulated with the epoxy resin composition in the cured state has high-temperature reliability, moisture-proof reliability, and thermal shock resistance. Use of any such composition proposed herein for semiconductor device encapsulation is a further aspect of the invention.

### FURTHER EXPLANATIONS; OPTIONS AND PREFERENCES

The semiconductor encapsulating epoxy resin composition of the invention comprises (A) an epoxy resin, (B) an optional curing agent, (C) an inorganic filler, (D) a cure accelerator, (E) a maleimide compound, and (E) an alkenyl phenol.

### A. Epoxy resin

The epoxy resin (A) in the epoxy resin composition of the invention is not critical. Illustrative examples of suitable epoxy resins include novolac type epoxy resins, cresol novolac type epoxy resins, triphenolalkane type epoxy resins, aralkyl type epoxy resins, biphenyl skeleton-containing aralkyl type epoxy resins, biphenyl type epoxy resins, dicyclopentadiene type epoxy resins, heterocyclic epoxy resins, naphthalene ring-containing epoxy resins, bisphenol A type epoxy compounds, bisphenol F type epoxy compounds, and stilbene type epoxy resins. These epoxy resins may be employed alone or in combination of two or more. Of these, aromatic ring-containing epoxy resins are preferred.

The epoxy resin used herein preferably has a hydrolyzable chlorine content of up to 1,000 ppm, especially up to 500 ppm and sodium and potassium contents of up to 10 ppm for each. If the content of hydrolyzable chlorine is more than 1,000 ppm or if the content of sodium or potassium is more than 10 ppm, moisture resistance may degrade when the encapsulated semiconductor device is long held in a hot humid environment.

### B. Curing agent

The curing agent (B) is not essential to the inventive composition. Any ordinary curing agents may be used as long as they do not compromise the objects of the invention. Typical curing agents are phenolic resins, examples of which include phenol novolac resins, naphthalene ring-containing phenolic resins, aralkyl type phenolic resins, triphenolalkane type phenolic resins, biphenyl skeleton-containing aralkyl type phenolic resins, biphenyl type phenolic resins, alicyclic phenolic resins, heterocyclic phenolic resins, naphthalene ring-containing phenolic resins, and bisphenol A and bisphenol F. These phenolic resins may be employed alone or in combination of two or more.

Like the epoxy resin, the curing agent used herein preferably has sodium and potassium contents of up to 10 ppm for each. If the content of sodium or potassium is more than 10 ppm, moisture resistance may degrade when the encapsulated semiconductor device is long held in a hot humid environment.

No particular limit is imposed on the proportion of component (B) relative to component (A). Generally, component (B) is used in an effective amount to cure the epoxy resin in a conventional manner. When a phenolic resin is used as the curing agent, it is preferably used in such amounts that the molar ratio of phenolic hydroxyl groups in the curing agent to epoxy groups in the epoxy resin is from 0.5 to 1.5, and more preferably from 0.8 to 1.2. Typically a phenolic resin for (B) is distinct from alkenyl phenols (F) described below, i.e. does not have alkenyl group.

### C. Inorganic filler

The inorganic filler (C) included in the epoxy resin compositions of the invention may be any suitable inorganic filler commonly used in epoxy resin compositions. Illustrative examples include silicas such as fused silica and crystalline silica, alumina, silicon nitride, aluminum nitride, boron nitride, titanium oxide, and glass fibers.

No particular limit is imposed on the mean particle size and shape of these inorganic fillers as well as the amount thereof. A mean particle size of 5 to 30 µm is preferred. The amount of the inorganic filler (C) loaded is preferably 200 to 1,200 parts, more preferably 300 to 1,000 parts by weight per 100 parts by weight of components (A), (E), (F) and optionally (B) combined.

The inorganic filler used herein is preferably surface treated beforehand with a coupling agent such as a silane coupling agent or a titanate coupling agent in order to increase the bonding strength between the resin and the inorganic filler. The preferred coupling agents are silane coupling agents including epoxy silanes such as
γ -glycidoxypropyltrimethoxysilane,
γ -glycidoxypropylmethyldiethoxysilane,
γ -isocyanatopropyltriethoxysilane,
γ -ureidopropyltriethoxysilane, and
β -(3,4-epoxycyclohexyl)ethyltrimethoxysilane;
amino silanes such as
N-β-(aminoethyl)-γ-aminopropyltrimethoxysilane,
γ -aminopropyltriethoxysilane, and
N-phenyl-γ-aminopropyltrimethoxysilane; and
mercapto silanes such as γ-mercaptopropyltrimethoxysilane. These coupling agents may be used alone or in admixture. No particular limitation is imposed on the amount of coupling agent used for surface treatment or the method of surface treatment.

### D. Curing accelerator

For promoting the cure reaction of the epoxy resin with the curing agent, the invention uses (D) a compound having the general formula (1). 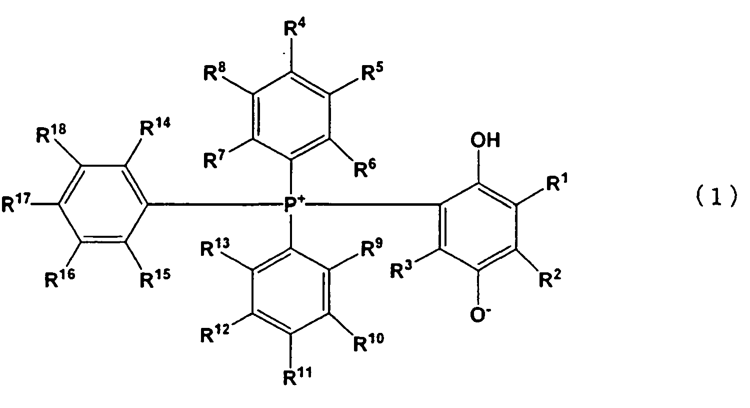 Herein R¹, R², and R³ are each independently hydrogen, a C₁-C₄ alkyl group, aryl group, or hydroxyl group, and R⁴ to R¹⁸ are each independently hydrogen, a C₁-C₄ alkyl group or alkoxy group.

Curing accelerators are used in prior art epoxy resin compositions. Known in the art are phosphorus compounds such as triphenylphosphine, tributylphosphine, tri(p-methylphenyl)phosphine, tri(nonylphenyl)phosphine, triphenylphosphine triphenylborane, and tetraphenylphosphine tetraphenylborate; tertiary amine compounds such as triethylamine, benzyldimethylamine, α-methylbenzyldimethylamine, and 1,8-diazabicyclo[5.4.0]undecene-7; and imidazole compounds such as 2-methylimidazole, 2-phenylimidazole, and 2-phenyl-4-methylimidazole. Phosphorus compounds are short in curing and molding abilities, and tertiary amine compounds and imidazole compounds have adverse impact on moisture-proof reliability.

However, we find that compounds of formula (1) can give compositions which are effectively moldable and have moisture-proof reliability.

It is not critical how to prepare a suitable addition compound of tertiary phosphine and benzoquinone as (D). When component (D) is compounded in the epoxy resin composition, it may be prepared in different ways. A first process involves combining and mixing tertiary phosphine and benzoquinone in a solvent in which both the reactants are soluble, allowing addition reaction to occur, and isolating the addition product, as taught in JP-A 2003-212958 and JP-A 2003-128757. In a second process, addition reaction of organophosphine and quinone is carried out in a phenolic resin as the curing agent, and the reaction product dissolved in the phenolic resin may be used without isolation, as taught in JP-A 2000-17052.

In the second process where addition reaction of tertiary phosphine and benzoquinone is carried out in a phenolic resin as the curing agent, some reaction products fail to exert a cure reaction accelerating effect as expected and interfere with continuous molding. The first process of combining and mixing the reactants in a solvent, followed by addition reaction and isolation is preferred.

In this case, one of the first processes is by adding the reactants to a solvent in which the reactants are highly soluble, but the addition product is less soluble, typically a ketone such as methyl isobutyl ketone, methyl ethyl ketone or acetone and agitating the mixture at room temperature to 80°C for 1 to 12 hours for effecting addition reaction. See Japanese Patent No. 3,295,643. However, if an aromatic solvent such as toluene is used, an addition product of tertiary phosphine with the aromatic solvent can form and be carried over in an amount of about 10%. Since this addition product can decompose substantially at temperatures of 170 to 200°C, the cured parts can become defective in outer appearance. If addition reaction is effected in a ketone solvent such as acetone, there are formed particles having a primary particle size of 1 to 5 µm and a secondary agglomerated particle size of 30 to 50 µm, within which the solvent is confined so that it is prevented from quick volatilizing. If this cure accelerator is used, the ketone solvent will gradually volatilize and deposit on the mold during a long-term molding process. As a result, the mold becomes adhesive to cured parts, interfering with the continuous molding. If the addition product is dried at high temperature for a long time, its properties can be degraded by oxidation.

On the other hand, if an ester solvent such as ethyl acetate or butyl acetate is used, prismatic crystals of about 10 µm are formed with the residual solvent minimized. The addition compound of tertiary phosphine and benzoquinone is formed in high purity. Since this avoids appearance defects due to volatiles in the cure accelerator, cured parts of quality can be manufactured by effective continuous molding. With respect to the preparation conditions, addition reaction is effected at a temperature of 40 to 90°C, more preferably 60 to 80°C, for a time of 0.5 to 3 hours, and the resulting precipitate is filtered, washed with (ester) solvent, and dried in vacuum at 80°C. In this way, an addition product with a purity of 98 to 100% is obtained.

The compound of formula (1) not only promotes the curing reaction between the epoxy resin and the curing agent, but is also effective as an accelerator for the curing reaction between the maleimide compound and the alkenyl phenol as components (E) and (F) described later. As the cure accelerator for the maleimide compound and the alkenyl phenol as components (E) and (F), a radical initiator such as a peroxide (e.g., benzoyl peroxide, dicumyl peroxide) or azo compound (e.g., azoisobutyronitrile) may be used in combination.

The cure accelerator (D) is blended in an effective amount, preferably in an amount of 0.1 to 5 parts, more preferably 0.5 to 3 parts by weight per 100 parts by weight of components (A), (E), (F) and optionally (B) combined. When the accelerator is allowed to act only as a radical initiator for the curing reaction between the maleimide compound and the alkenyl phenol as components (E) and (F), on the other hand, it is preferably blended in an amount of 0.05 to 3 parts, more preferably 0.1 to 1 part by weight on the same basis.

### E. Maleimide compound

Component (E) is a compound having at least two maleimide groups in a molecule. Although its structure is not particularly limited, suitable compounds include N,N'-4,4'-diphenylmethanebismaleimide and N,N'-(3,3'-dimethyl-4,4'-diphenylmethane)bismaleimide. One preferred maleimide compound is BMI bismaleimide (KI Chemicals Co., Ltd.) of the formula shown below.

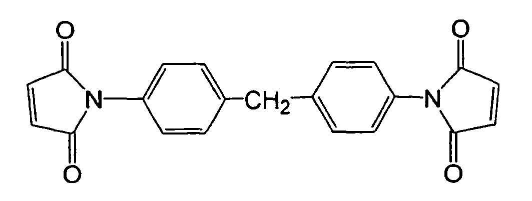

The amount of the maleimide compound (E) added is not particularly limited. In general, epoxy resin compositions with higher proportions of the maleimide compound have higher Tg. However, compositions containing more than 60% by weight of component (E) based on the total weight of components (A), (B), (E) and (F) are less flowable, suffering molding defects like wire sway. For a good balance of encapsulation properties, the proportion of the maleimide compound is preferably about 30 to 60% by weight, more preferably about 40 to 50% by weight based on the total weight of components (A), (B), (E) and (F).

### F. Alkenyl phenol

Component (F) is a phenol having at least one alkenyl group in a molecule. Suitable such phenols include o,o'-diallyl-bisphenol A, o,o'-di(1-propenyl)-bisphenol A, o-allylphenol novolac resins, o-(1-propenyl)phenol novolac resins, tris-o-allylphenolalkane type phenolic resins, and tris-o-(1-propenyl)phenolalkane type phenolic resins. For reactivity with the maleimide compound, 1-propenyl-containing compounds such as o,o'-di(1-propenyl)-bisphenol A, o-(1-propenyl)phenol novolac resins, and o-(1-propenyl)phenolalkane type phenolic resins are desirable.

Typical of the alkenyl-containing phenol compounds are o-(1-propenyl)phenol novolac resins shown below: 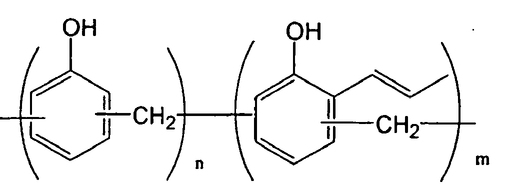 wherein m = 1-100, n = 1-100, and m+n = 2-200.

The amount of the alkenyl-containing phenol compound added is desirably 0.01 to 1.0 mole, more desirably 0.2 to 0.5 mole per mole of maleimide groups, but not limited thereto.

In addition to the foregoing components (A) to (F), the semiconductor encapsulating epoxy resin compositions of the invention may further include various additives, if necessary and as long as the objects of the invention are not impaired. Exemplary additives include stress reducing agents such as thermoplastic resins, thermoplastic elastomers, organic synthetic rubbers, and silicones; waxes such as carnauba wax, higher fatty acids, and synthetic waxes; coloring agents such as carbon black; and halogen trapping agents.

Parting agents which can be used herein include carnauba wax, rice wax, polyethylene, polyethylene oxide, montanic acid, and montan waxes in the form of esters of montanic acid with saturated alcohols, 2-(2-hydroxyethylamino)ethanol, ethylene glycol, glycerin or the like; stearic acid, stearic esters, stearamides, ethylene bisstearamide, ethylene-vinyl acetate copolymers, and the like, alone or in admixture of two or more. The parting agent is desirably included in an amount of 0.1 to 5 parts, more desirably 0.3 to 4 parts by weight per 100 parts by weight of components (A) and (B) combined.

### Preparation

The inventive epoxy resin compositions may be prepared as a molding material by compounding components (A) to (F) and optional additives in predetermined proportions, intimately mixing these components together in a mixer, ball mill or the like, then melting and working the resulting mixture using a hot roll mill, kneader, extruder or the like. The mixture is then cooled and solidified, and subsequently ground to a suitable size so as to give a molding material.

When the components are mixed in a mixer or the like to form a uniform composition, it is preferred for improved shelf stability of the resulting composition to add a silane coupling agent as a wetter to carry out previous surface treatment.

Examples of suitable silane coupling agents include
γ -glycidoxypropyltrimethoxysilane,
γ -glycidoxypropylmethyldiethoxysilane,
γ -glycidoxypropyltriethoxysilane, p-styryltrimethoxysilane,
γ -methacryloxypropylmethyldimethoxysilane,
γ -methacryloxypropyltrimethoxysilane,
γ -methacryloxypropylmethyldiethoxysilane,
γ -methacryloxypropyltriethoxysilane,
γ -acryloxypropyltrimethoxysilane,
N-β-(aminoethyl)-γ-aminopropylmethyldimethoxysilane,
N-β-(aminoethyl)-γ-aminopropyltrimethoxysilane,
N-β-(aminoethyl)-γ-aminopropyltriethoxysilane,
γ -aminopropyltrimethoxysilane, γ-aminopropyltriethoxysilane,
N-phenyl-γ-aminopropyltrimethoxysilane,
γ -mercaptopropylmethyldimethoxysilane,
γ -mercaptopropyltrimethoxysilane,
bis(triethoxypropyl)tetrasulfide, and
γ -isocyanatopropyltriethoxysilane. No particular limits are imposed on the amount of silane coupling agent used for surface treatment and the surface treating procedure.

The resulting epoxy resin compositions of the invention can be effectively used for encapsulating various types of semiconductor devices. The encapsulation method most commonly used is low-pressure transfer molding. The epoxy resin composition of the invention is preferably molded and cured at a temperature of about 150 to 180°C for a period of about 30 to 180 seconds, followed by post-curing at about 150 to 180°C for about 2 to 16 hours.

The epoxy resin compositions of the invention comply with a continuous molding process and cure into parts which exhibit improved crack resistance upon soldering even when the encapsulating resin portion of surface mount packages has absorbed moisture.

### EXAMPLE

Examples and Comparative Examples are given below for further illustrating the invention, but are not intended to limit the invention.

### Examples 1-5 & Comparative Examples 1-6

Epoxy resin compositions for semiconductor encapsulation were prepared by uniformly melt mixing the components shown in Tables 1 and 2 in a hot twin-roll mill, followed by cooling and grinding. Properties (i) to (vii) of these compositions were measured by the following methods. The results are also shown in Tables 1 and 2.

### (i) Molding

Using a continuous molding machine, each composition was molded at a temperature of 175°C and a pressure of 70 MPa for a time of 90 seconds, to produce quad flat packages (QFP) (14 mm × 20 mm × 2.7 mm, 5 cavities). The number of shots was counted until any failure occurred, for example, the package or cull stuck to the mold.

### (ii) Tg

Each composition was molded at 175°C and 6.9 N/mm² for 90 seconds into a rod of 10 × 4 × 50 mm and post-cured at 260°C for 4 hours. From a dynamic viscoelasticity spectrum, a glass transition temperature (Tg) was determined at a frequency of 5 Hz.

### (iii) Reliability during hot storage

A silicon chip measuring 6x6 mm on which aluminum wiring had been formed was adhesively bonded to a 14-pin dual in-line package (DIP) frame (Alloy 42), and the aluminum electrodes on the chip surface were wire bonded to the lead frame using gold wire having a diameter of 25 µm. The epoxy resin composition was then molded over the chip at a temperature of 175°C and a pressure of 6.9 N/mm² for a time of 120 seconds, and post-cured at 260°C for 4 hours. Twenty packages thus obtained were left to stand for a certain time (500 or 1000 hours) in an atmosphere of 200°C. Their electric resistance values were measured. Those samples whose resistance increased to 150% of the initial value were regarded defective. The time when the number of defective samples exceeded 50% was recorded.

### (iv) Moisture resistance

A silicon chip measuring 6x6 mm on which aluminum wiring had been formed was adhesively bonded to a 14-pin DIP frame (Alloy 42), and the aluminum electrodes on the chip surface were wire bonded to the lead frame using gold wire having a diameter of 25 µm. The epoxy resin composition was then molded over the chip at a temperature of 175°C and a pressure of 6.9 N/mm² for a time of 120 seconds, and post-cured at 260°C for 4 hours. Twenty packages thus obtained were left to stand for 1000 hours in an atmosphere of 140°C and RH 85% while being subjected to a DC bias voltage of -5 V. The number of packages in which aluminum corrosion arose was counted. The result is a percentage per 20 packages.

### (v) Thermal shock resistance

A silicon chip measuring 10×10 mm on which aluminum wiring had been formed was adhesively bonded to a quad flat package (QFP) (14 mm × 20 mm × 2.7 mm). The epoxy resin composition was then molded over the chip at a temperature of 175°C and a pressure of 6.9 N/mm² for a time of 120 seconds, and post-cured at 260°C for 4 hours. Twenty packages thus obtained were alternately immersed in liquefied nitrogen for 30 seconds and a solder bath (260°C) for 60 seconds. This test was repeated 100 cycles before the packages were inspected for cracks and delamination. The result is a percentage of defective packages per 20 packages.

### (vi) Dielectric constant

Each composition was molded at 175°C and 6.9 N/mm² for 120 seconds into a disc of 50 mm diameter and 3 mm thick and post-cured at 260°C for 4 hours. The dielectric constant of the disc was measured according to JIS K6911.

### Components

### A. Epoxy resin

(a) o-cresol novolac epoxy resin EOCN 1020-65 by Nippon Kayaku K.K. (epoxy equivalent 200)
(b) Trifunctional epoxy resin EPPN-502H by Nippon Kayaku K.K. (epoxy equivalent 168)

### B. Curing agent

Phenol novolac resin DL-92
by Meiwa Kasei K.K. (phenolic hydroxyl equivalent 110)

### C. Inorganic filler

Spherical fused silica (mean particle size 20 µm)
by Tatsumori K.K.

### D. Cure accelerator

(a) Compound of formula (2): 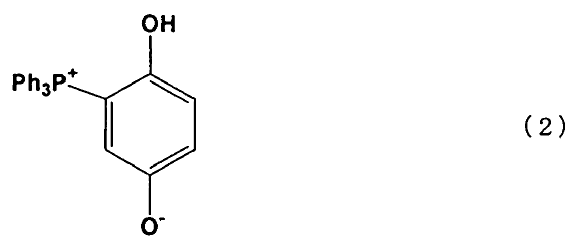
(b) Triphenylphosphine TPP (Hokko Chemical Co., Ltd.)
(c) Imidazole compound (ZEP: Shikoku Kasei Co., Ltd.)

### Preparation Method of Cure Accelerator (a)

832.0 g of triphenylphosphine (Hokko Chemical Co., Ltd.) was dissolved in 1800.0 g of butyl acetate, followed by agitating the solution at 80°C for 30 minutes. 352.0 g of 1,4-benzoquinone in 1800 g of butyl acetate was dropped at a rate of 145 g/min. After the completion of dropping, the reaction mixture was agitated for one hour for aging, and then was cooled to room temperature. The precipitate was collected by filtration, washed and dried at a reduced pressure to obtain 982.7 g of the addition product of triphenylphosphine and 1,4-benzoquinone.

### E. Maleimide compound

Bismaleimide compound represented by the following formula (BMI: KI Chemicals Co., Ltd.)

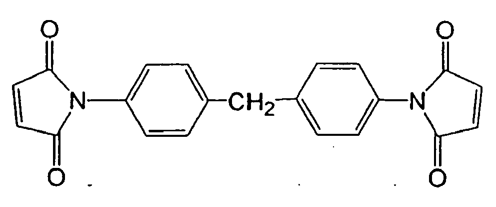

### F. Alkenyl phenol

o-(1-propenyl)phenol novolac resin represented by the following formula (1PP-2: Gunei Chemical Co., Ltd.)

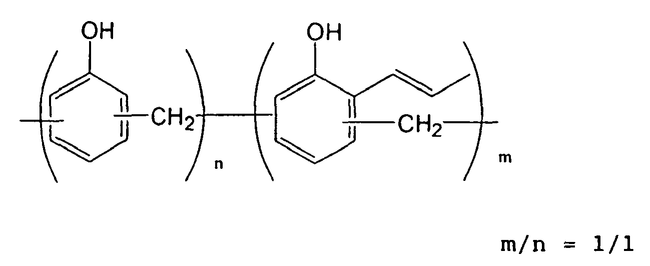

### Other additives

Radical polymerization initiator: Percumyl D (NOF Corp.)
Parting agent: Carnauba Wax (Nikko Fine Products Co., Ltd.)
Silane coupling agent: γ-glycidoxypropyltrimethoxysilane KBM-403 (Shin-Etsu Chemical Co., Ltd.)

**Table 1**

| Formulation (pbw) | | Example | | | | |
|---|---|---|---|---|---|---|
| | | 1 | 2 | 3 | 4 | 5 |
| (A) Epoxy (A) resin | EOCN-1020-65 | | | 45 | 45 | 30 |
| | EPPN-502H | 40 | 40 | | | |
| (B) Curing agent | | 5 | 5 | 5 | 17 | 2 |
| (C) Inorganic filler | | 500 | 500 | 500 | 500 | 500 |
| (D) Cure accelerator | compound (2) | 1.5 | 1.5 | 2 | 2 | 2 |
| | TPP | | | | | |
| | 2PZ | | | | | |
| (E) Maleimide compound | | 40 | 40 | 40 | 30 | 50 |
| (F) Alkenyl phenol | | 15 | 15 | 10 | 8 | 18 |
| Additives | Radical polymerization | | 0.5 | | 0.5 | |
| | Parting agent | 1.5 | 1.5 | 1.5 | 1.5 | 1.5 |
| | Carbon black | 1.5 | 1.5 | 1.5 | 1.5 | 1.5 |
| | Silane coupling agent | 1.0 | 1.0 | 1.0 | 1.0 | 1.0 |
| Properties | Molding (shots) | 500< | 500< | 500< | 500< | 500< |
| | Tg (°C) | 320 | 340 | 300 | 280 | 350 |
| | Hot storage reliability (hr) | 1000< | 1000< | 1000< | 1000< | 1000< |
| | Moisture resistance (%) | 0 | 0 | 0 | 0 | 0 |
| | Thermal shock resistance (%) | 0 | 0 | 0 | 0 | 0 |
| | Dielectric constant @1MHz | 3.8 | 3.8 | 3.7 | 3.7 | 3.5 |

**Table 2**

| Formulation (pbw) | | Comparative Example | | | | | |
|---|---|---|---|---|---|---|---|
| | | 1 | 2 | 3 | 4 | 5 | 6 |
| (A) Epoxy A) resin | EOCN-1020-65 | | | | | | |
| | EPPN-502H | 40 | 40 | 50 | 30 | 60 | |
| (B) Curing agent | | 5 | 5 | 50 | 30 | | |
| (C) Inorganic filler | | 500 | 500 | 500 | 500 | 500 | 500 |
| (D) Cure accelerator | compound (2) | | | 1.5 | 1.5 | 1.5 | 1.5 |
| | TPP | 2 | | | | | |
| | 2PZ | | 2 | | | | |
| (E) Maleimide compound | | 40 | 40 | | 40 | | 50 |
| (F) Alkenyl phenol | | 15 | 15 | | | 40 | 50 |
| Additives | Radical polymerization initiator | 0.5 | 0.5 | | 0.5 | | |
| | Parting agent | 1.5 | 1.5 | 1.5 | 1.5 | 1.5 | 1.5 |
| | Carbon black | 1.5 | 1.5 | 1.5 | 1.5 | 1.5 | 1.5 |
| | Silane coupling agent | 1.0 | 1.0 | 1.0 | 1.0 | 1.0 | 1.0 |
| Properties | Molding (shots) | 20 | 300 | 500< | 10 | 10 | 2 |
| | Tg (°C) | 320 | 330 | 220 | 220 | 180 | 320 |
| | Hot storage reliability (hr) | 1000< | 1000< | 1000< | 500 | 500 | 500 |
| | Moisture resistance (%) | 0 | 100 | 0 | 0 | 50 | 100 |
| | Thermal shock resistance (%) | 0 | 0 | 100 | 100 | 100 | 100 |
| | Dielectric constant @1MHz | 3.6 | 3.8 | 4.2 | 3.8 | 4.2 | 3.3 |

As evident from the data of Table 1, the epoxy resin compositions within the scope of the invention are effectively moldable and cure into products having a high Tg and a low dielectric constant. Semiconductor packages encapsulated with the epoxy resin compositions in the cured state remain fully reliable at high temperature and under moisture, and resistant to thermal shocks.

## Claims

1. A semiconductor encapsulating epoxy resin composition comprising
(A) epoxy resin,
(C) inorganic filler,
(D) cure accelerator having the general formula (1): 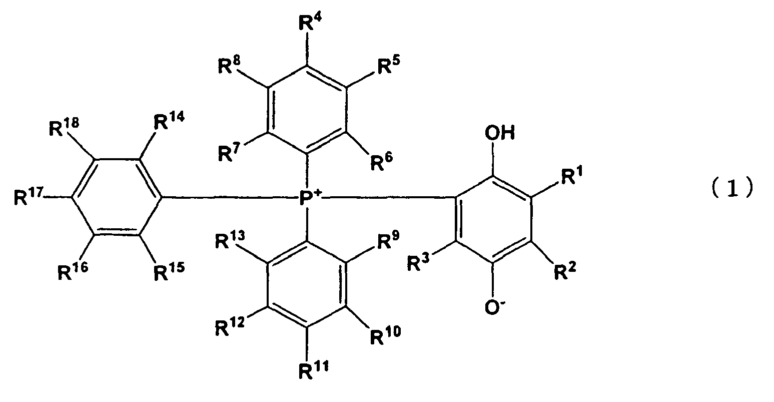 wherein R¹, R², and R³ are each independently hydrogen, C₁-C₄ alkyl, aryl, or hydroxyl, and R⁴ to R¹⁸ are each independently hydrogen, C₁-C₄ alkyl or alkoxy.
(E) compound having at least two maleimide groups in a molecule, and
(F) phenol having at least one alkenyl group in a molecule.

2. The composition of claim 1, further comprising (B) phenolic resin curing agent.

3. A semiconductor device encapsulated with a cured product of the epoxy resin composition of claim 1 or 2.

4. Use of a composition according to claim 1 or 2 for encapsulation of semiconductor devices.

## Patentansprüche

1. Epoxyharzzusammensetzung zum Vergießen eines Halbleiters, umfassend:
(A) Epoxyharz,
(C) anorganischen Füllstoff,
(D) Härtungsbeschleuniger der allgemeinen Formel (1): 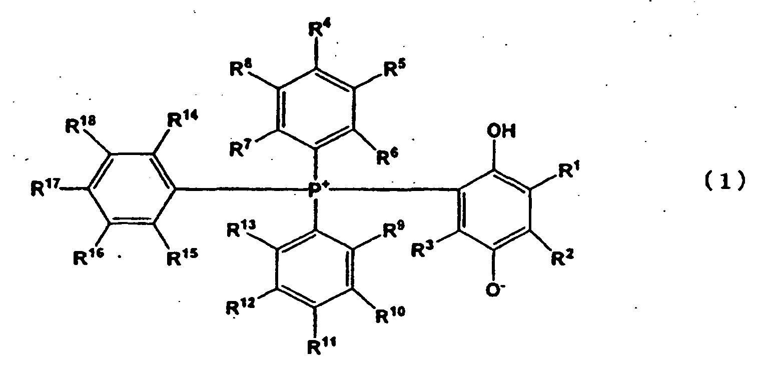 worin R¹, R² und R³ jeweils unabhängig voneinander Wasserstoff, C₁-C₄-Alkyl, Aryl oder Hydroxyl sind und R⁴ bis R¹⁸ jeweils unabhängig voneinander Wasserstoff, C₁-C₄-Alkyl oder -Alkoxy sind;
(E) Verbindung mit zumindest zwei Maleinimidgruppen pro Molekül und
(F) Phenol mit zumindest einer Alkenylgruppe pro Molekül.

2. Zusammensetzung nach Anspruch 1, weiters umfassend (B) ein Phenolharzhärtungsmittel.

3. Halbleitervorrichtung, die mit einem gehärteten Produkt der Epoxyharzzusammensetzung nach Anspruch 1 oder 2 vergossen ist.

4. Verwendung einer Zusammensetzung nach Anspruch 1 oder 2 zum Vergießen von Halbleitervorrichtungen.

## Revendications

1. Composition de résine époxy pour encapsuler un semi-conducteur comprenant
(A) une résine époxy,
(C) une charge inorganique,
(D) un accélérateur de vulcanisation répondant à la formule générale (1) : 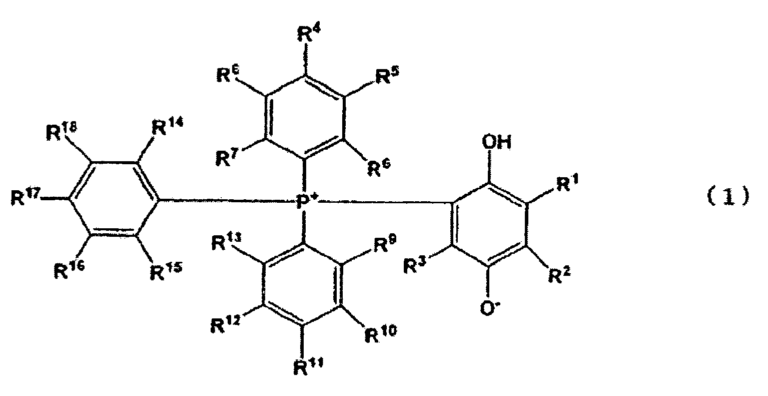 dans laquelle R¹, R² et R³ sont chacun indépendamment un atome d'hydrogène, un groupe alkyle en C₁ à C₄, aryle ou hydroxyle, et R⁴ à R¹⁸ sont chacun indépendamment un atome d'hydrogène, un groupe alkyle en C₁ à C₄ ou alcoxy,
(E) un composant comprenant au moins deux groupes maléimide dans une molécule, et
(F) un phénol comportant au moins un groupe alcényle dans une molécule.

2. Composition selon la revendication 1, comprenant en outre (B) un agent de vulcanisation à base de résine phénolique.

3. Dispositif de semi-conducteur encapsulé avec un produit vulcanisé de la composition de résine époxy selon la revendication 1 ou 2.

4. Utilisation d'une composition selon la revendication 1 ou 2, pour l'encapsulation de dispositifs de semi-conducteur.
